# EUROPÄISCHE PATENTSCHRIFT

(11) **EP 1 911 103 B1**
(45) Veröffentlichungstag und Bekanntmachung des Hinweises auf die Patenterteilung: **31.08.2016**
(21) Anmeldenummer: 06775767.4
(22) Anmeldetag: 28.07.2006
(51) Int. Cl.: H01L 33/04, H01S 5/343, H01S 5/34, H01L 33/06, H01L 33/32, H01S 5/30, H01S 5/32

(54) **OPTOELEKTRONISCHER HALBLEITERCHIP**
OPTOELECTRONIC SEMICONDUCTOR CHIP
PUCE SEMI-CONDUCTRICE OPTOELECTRONIQUE

(30) Priorität: 29.07.2005 DE 102005035722
(43) Veröffentlichungstag der Anmeldung: 16.04.2008
(73) Patentinhaber: OSRAM Opto Semiconductors GmbH, 93055 Regensburg (DE)
(72) Erfinder: AVRAMESCU, Adrian, 93051 Regensburg (DE); HÄRLE, Volker, 93164 Laaber (DE); HÖPPEL, Lutz, 93087 Alteglofsheim (DE); PETER, Matthias, 93055 Regensburg (DE); SABATHIL, Matthias, 93059 Regensburg (DE); STRAUSS, Uwe, 93077 Bad Abbach (DE)
(74) Vertreter: Epping - Hermann - Fischer
(86) Internationale Anmeldenummer: PCT/DE2006/001323
(87) Internationale Veröffentlichungsnummer: WO 2007/012327

(56) Entgegenhaltungen:
- EP-A- 1 394 865
- WO-A-02/093658
- WO-A2-01/41224
- DE-A1- 10 213 358
- DE-A1- 19 955 747
- US-A- 6 057 564
- US-A1- 2003 003 613
- US-A1- 2003 151 042
- US-A1- 2004 159 843
- US-A1- 2004 222 431

## Beschreibung

Es wird ein optoelektronischer Halbleiterchip angegeben.

Die Druckschriften US 2003/0151042 A1, US 2003/0085409A1, WO 02/093658 A und US 6,057,564 A beschreiben jeweils einen optoelektronischen Halbleiterchip.

US 2003/151042 beschreibt dabei einen optoelektronischen Halbleiterchip gemäß dem Oberbegriff des Anspruchs 1.

Aufgabe ist es, einen optoelektronischen Halbleiterchip mit verbesserter Effizienz anzugeben.

Die Erfindung betrifft einen optoelektronischen Halbleiterchip gemäß Anspruch 1 und ein Verfahren zur Herstellung eines optoelektronischen Halbleiterchips gemäß Anspruch 16.

Gemäß zumindest einer Ausführungsform des optoelektronischen Halbleiterchips weist der optoelektronische Halbleiterchip eine p-dotierte Barriereschicht für einen aktiven Bereich des Halbleiterchips auf, die dem aktiven Bereich in einer Wachstumsrichtung gesehen vorgeordnet ist. Das heißt, von einem Wachstumssubstrat des Halbleiterchips aus gesehen, folgt zunächst die p-dotierte Barriereschicht für den aktiven Bereich und dann der aktive Bereich. Die p-dotierte Barriereschicht (Confinementschicht) ist damit räumlich näher am Wachstumssubstrat angeordnet als der aktive Bereich. Bei der p-dotierten Barriereschicht handelt es sich bevorzugt um eine p-Barriereschicht für den aktiven Bereich. Die p-dotierte Barriereschicht kann eine Mehrzahl von Monolagen eines p-dotierten Materials umfassen.

Gemäß zumindest einer Ausführungsform des optoelektronischen Halbleiterchips ist der p-dotierten Barriereschicht in Wachstumsrichtung ein aktiver Bereich des Halbleiterchips nachgeordnet. Bevorzugt ist der aktive Bereich zur Strahlungserzeugung geeignet. Das heißt, wird ein elektrischer Strom in den Halbleiterchip eingeprägt, so wird im aktiven Bereich durch Rekombination von Ladungsträgern elektromagnetische Strahlung erzeugt, die den Halbleiterchip zumindest zum Teil verlässt. Der aktive Bereich ist dabei bevorzugt durch eine Abfolge von Schichten gegeben.

Gemäß zumindest einer Ausführungsform des optoelektronischen Halbleiterchips basiert der aktive Bereich auf einem hexagonalen Verbindungshalbleiter.

Dies bedeutet im vorliegenden Zusammenhang, dass der aktive Bereich oder zumindest eine Schicht des aktiven Bereichs einen hexagonalen Verbindungshalbleiter umfasst. Das heißt, zumindest der aktive Bereich weißt dann eine hexagonale Gitterstruktur auf. Beispielsweise basiert der gesamte optoelektronische Halbleiterchip dann auf einem hexagonalen Verbindungshalbleiter. Das heißt, das Halbleitermaterial des Halbleiterchips weist eine hexagonale Gitterstruktur auf.

Bei dem hexagonalen Verbindungshalbleiter handelt es sich beispielsweise um Halbleiterstrukturen aus binären, ternären und/oder quaternären Verbindungen von Elementen der II. und VI. Hauptgruppe des Periodensystems der chemischen Elemente. Beispielsweise kann es sich um eine der folgenden Verbindungen handeln: ZnO, ZnMgO, CdS, ZnCdS, MgBeO. Weiter kann es sich bei dem hexagonalen Verbindungshalbleiter um eine Halbleiterstruktur aus einer binären, ternären und/oder quaternären Verbindung von Elementen der III. Hauptgruppe mit einem Nitrid handeln. Es kann sich zum Beispiel um eine der folgenden Halbleiterstrukturen handeln: BN, AlGaN, GaN, AlGaInN oder weiteren III-V-Verbindungen.

Dabei muss das Verbindungshalbleitermaterial im aktiven Bereich nicht zwingend eine mathematisch exakte

Zusammensetzung nach einer der obigen Formel aufweisen. Vielmehr kann es einen oder mehrere Dotierstoffe sowie zusätzliche Bestandteile aufweisen, die die charakteristischen physikalischen Eigenschaften des Materials im Wesentlichen nicht ändern. Der Einfachheit halber beinhalten obige Formeln jedoch nur die wesentlichen Bestandteile des Kristallgitters, auch wenn diese teilweise durch geringere Mengen weitere Stoffe ersetzt sein können.

Gemäß zumindest einer Ausführungsform des optoelektronischen Halbleiterchips ist dem aktiven Bereich in Wachstumsrichtung eine n-dotierte Barriereschicht des aktiven Bereichs. nachgeordnet. Das heißt, die n-dotierte Barriereschicht folgt dem aktiven Bereich in Wachstumsrichtung nach. Die n-dotierte Barriereschicht ist damit räumlich weiter vom Wachstumssubstrat entfernt als der aktive Bereich. Die n-dotierte Barriereschicht umfasst bevorzugt eine Mehrzahl von Monolagen eines n-dotierten Materials. Die n-dotierte Barriereschicht stellt eine Barriereschicht für den aktiven Bereich dar.

Gemäß zumindest einer Ausführungsform des optoelektronischen Halbleiterchips weist der Halbleiterchip in einer Wachstumsrichtung folgende Abfolge von Bereichen auf: Eine p-dotierte Barriereschicht für den aktiven Bereich, den aktiven Bereich, der zur Erzeugung elektromagnetischer Strahlung geeignet ist, und auf einem hexagonalen Verbindungshalbleiter basiert und eine n-dotierte Barriereschicht für den aktiven Bereich. Das heißt, in Wachstumsrichtung gesehen folgt einer p-Barriereschicht für den aktiven Bereich der aktive Bereich nach, dem wiederum eine n-Barriereschicht für den aktiven Bereich nachfolgt. Die p- und n-Barriereschichten begrenzen dabei die Ladungsträger im aktiven Bereich. Bevorzugt ist die Wachstumsrichtung parallel zur kristallographischen c-Achse des Halbleiterchips.

Gemäß der vorliegenden Erfindung basiert der aktive Bereich des optoelektronischen Halbleiterchips auf dem III-V-Halbleitermaterialsystem In_{y}Ga_{1-x-y}AlₓN mit 0 ≤ x ≤ 1, 0 ≤ y ≤ 1 und x + y ≤ 1.

Dies bedeutet im vorliegenden Zusammenhang, dass der aktive Bereich oder zumindest eine Schicht des aktiven Bereichs ein Nitrid-III/V-Verbindungshalbleitermaterial, vorzugsweise In_{y}Ga_{1-x-y}AlₓN umfasst, wobei 0 ≤ x ≤ 1, 0 ≤ y ≤ 1 und x+y ≤ 1 gilt. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des In_{y}Ga_{1-x-y}AlₓN-Materials im Wesentlichen nicht ändern. Der Einfachheit halber beinhaltet obige Formel jedoch nur die wesentlichen Bestandteile des Kristallgitters wie Al, Ga, In, N, auch wenn diese teilweise durch geringe Mengen weiterer Stoffe ersetzt sein können.

Bevorzugt ist der aktive Bereich im Betrieb des Halbleiterchips geeignet, elektromagnetische Strahlung in zumindest einem der folgenden Spektralbereiche zu erzeugen: Ultraviolett, Blau, Blau-Grün, Gelb, Rot. Beispielsweise kann die Emissionswellenlänge mittels der Indium-Konzentration eingestellt sein. Bevorzug basiert der aktive Bereich dazu auf dem III-V-Halbleitermaterialsystem In_{y}Ga_{1-y}N mit 0 < y ≤ 1.

Gemäß zumindest einer Ausführungsform des optoelektronischen Halbleiterchips weist der Halbleiterchip in einer Wachstumsrichtung folgende Abfolge von Bereichen auf: Eine p-dotierte Barriereschicht für den aktiven Bereich, den aktiven Bereich, der zur Erzeugung elektromagnetischer Strahlung geeignet ist, und auf dem III-V-Halbleitermaterialsystem In_{y}Ga_{1-x-y}AlₓN mit 0 ≤ x ≤ 1, 0 ≤ y ≤ 1 und x + y ≤ 1 basiert und eine n-dotierte Barriereschicht für den aktiven Bereich. Das heißt, in Wachstumsrichtung gesehen folgt einer p-Barriereschicht für den aktiven Bereich der aktive Bereich nach, dem wiederum eine n-Barriereschicht für den aktiven Bereich nachfolgt. Die p- und n- Barriereschichten begrenzen dabei die Ladungsträger im aktiven Bereich. Der Halbleiterchip ist dabei bevorzugt im Ga-face Wachstumsmodus gewachsen. Die Wachstumsrichtung ist parallel zur kristallographischen c-Achse.

Der optoelektronische Halbleiterchip macht sich dabei unter anderem die folgende Erkenntnis zu nutze. Bei einem hexagonalen Verbindungshalbleiter - insbesondere bei einem auf dem III-V-Halbleitermaterialsystem In_{y}Ga_{1-x-y}AlₓN mit 0 ≤ x ≤ 1, 0 ≤ y ≤ 1 und x + y ≤ 1 basierenden Halbleiterchip - treten im aktiven Bereich, der beispielsweise InGaN-Quantentröge umfassen kann, piezoelektrische Felder aufgrund der polaren Wurtzit-Kristallstruktur und der Verspannung im aktiven Bereich auf. Diese piezoelektrischen Felder sind entlang der Wachstumsrichtung ausgerichtet. Die Polung dieser Felder ist abhängig vom Wachstumsmodus, in dem der Halbleiterchip gewachsen wird. Beispielsweise bei Verwendung der metallorganischen Gasphasenepitaxie (MOVPE) wird bevorzugt im Ga-Face Wachstumsmodus gewachsen. Beispielsweise für eine GaN Kristall bedeutet dies dass bei den Ga-N Doppelschichten, aus denen der Kristall gebildet ist, die Galliumatome in Richtung der vom Wachstumssubstrat abgewandten Oberfläche des Kristalls liegen. Die kristallographische c-Achse und das elektrische Feld zeigen bei im Ga-Face Wachstumsmodus gewachsenen Kristallen, bei denen die Wachstumsrichtung parallel zur kristallographischen c-Achse verläuft, vom Substrat weg zur Kristalloberfläche. Die Polarisation der piezoelektrischen Felder aufgrund der Verspannungen im aktiven Bereich hat die entgegen gesetzte Richtung. Die durch die Polarisation induzierten Gitterladungen sind negativ an der der Kristalloberfläche zugewandten Seite des aktiven Bereichs und positiv an der der Schnittstelle von Substrat und aufgewachsenem Kristall zugewandten Seite des aktiven Bereichs. Die Polung der piezoelektrischen Felder in Richtung der c-Achse lässt sich im Ga-face Wachstumsmodus nur schwer beeinflussen.

Bei einer Abfolge von Schichten um den aktiven Bereich, bei der in Wachstumsrichtung, das heißt, parallel zur kristallographischen c-Achse, n-Barriereschicht, aktiver Bereich, p-Barriereschicht aufeinander abfolgen, führen die piezoelektrischen Felder dabei zu einer ungünstigen Barrierenstruktur, die die Injektion von Ladungsträgern in den aktiven Bereich erschwert. Bedingt dadurch weisen solche optoelektronischen Halbleiterchips eine interne Quanteneffizienz auf, die mit der Dichte des in den Halbleiterchip eingeprägten Stroms stark abfällt. Die vorgeschlagene Abfolge in Wachstumsrichtung p-dotierte Barriereschicht, aktiver Bereich, n-dotierte Barriereschicht nutzt diese Polung der piezoelektrischen Felder aus, um den Einfang von Ladungsträgern im aktiven Bereich zu unterstützen. Die piezoelektrischen Felder tragen also bei dieser Reihenfolge des Schichtaufbaus zu einem verbesserten Einfang von Ladungsträgern im aktiven Bereich bei. Die interne Quanteneffizienz wird dadurch nahezu unabhängig von der Stromdichte.

Gemäß zumindest einer Ausführungsform des optoelektronischen Halbleiterchips ist zwischen p-dotierter Barriereschicht und dem aktiven Bereich eine Diffusionsbarriere angeordnet. Die Diffusionsbarriere ist geeignet, ein Eindringen des p-Dotierstoffs aus der Barriereschicht in den aktiven Bereich zu behindern. Das heißt, nur ein sehr geringer Anteil des p-Dotierstoffes kann durch die Diffusionsbarriere aus der p-dotierten Barriereschicht in den aktiven Bereich gelangen. Die Diffusionsbarriere ist dabei in Wachstumsrichtung gesehen der p-dotierten Barriereschicht nachgeordnet und dem aktiven Bereich vorgeordnet. Die Diffusionsbarriere kann direkt zwischen p-dotierter Barriereschicht und aktivem Bereich angeordnet sein. Das heißt, die Diffusionsbarriere weist dann mit beiden Bereichen des optoelektronischen Halbleiterchips jeweils eine Grenzfläche auf. Die Diffusionsbarriere umfasst bevorzugt eine Mehrzahl von Schichten, die sich in ihrer Zusammensetzung - beispielsweise in ihrer Dotierung oder dem Grad ihrer Dotierung - unterscheiden können. Bevorzugt ist die Barriereschicht geeignet, die Diffusion eines p-Dotierstoffes wie beispielsweise die Diffusion von Magnesium zu behindern.

Gemäß der vorliegenden Erfindung ist in Wachstumsrichtung gesehen der p-Barriereschlcht des optoelektronischen Halbleiterchips ein Tunnelkontakt vorgeordnet. Dieser Tunnelkontakt ist also näher an einem Wachstumssubstrat des optoelektronischen Halbleiterchips angeordnet als die p-dotierte Barriereschicht. Bevorzugt grenzt der Tunnelkontakt direkt an die p-dotierte Barriereschicht an, das heißt, der Tunnelkontakt weist mit dieser Barriereschicht eine Grenzfläche auf.

Der Tunnelkontakt weist einen hoch n-dotierten Bereich auf, der der p-dotierten Barriereschicht abgewandt ist. Weiter weist der Tunnelkontakt einen hoch p-dotierten Bereich auf, der der p-dotierten Barriereschicht zugewandt ist. Weiter weist der Tunnelkontakt eine Diffusionsbarriere zwischen den beiden Bereichen des Tunnelkontakts auf. Die Diffusionsbarriere ist geeignet, eine Diffusion zumindest des p-Dotierstoffs in den n-dotierten Bereich des Tunnelkontakts zu hemmen oder zu verhindern.

Gemäß zumindest einer Ausführungsform des optoelektronischen Halbleiterchips ist dem Tunnelkontakt ein n-leitender Bereich des Halbleiterchips in Wachstumsrichtung gesehen vorgeordnet. Das heißt, der n-leitende Bereich befindet sich räumlich näher am Wachstumssubstrat als der Tunnelkontakt. Bevorzugt grenzt der n-leitende Bereich direkt an den Tunnelkontakt an. Besonders bevorzugt weist der n-leitende Bereich mit dem Tunnelkontakt eine Grenzfläche auf. Der Tunnelkontakt verbindet dann den n-leitenden Bereich mit der p-dotierten Barriereschicht. Der Tunnelkontakt dient zur Einprägung von Ladungsträgern in die p-dotierte Barriereschicht.

Der optoelektronische Halbleiterchip macht sich dabei unter anderem die Idee zunutzte, dass es mit Hilfe des Tunnelkontakts möglich ist, zwischen n-leitendem Bereich und p-dotierter Barriereschicht, ein n-leitendes Wachstumssubstrat zum Aufwachsen des optoelektronischen Halbleiterchips zu nutzen. Dies hat den Vorteil, dass der Stromtransport weitestgehend im gut elektrisch leitenden n-leitenden Bereich stattfinden kann. Der Strom wird durch den Tunnelkontakt dann in die im Vergleich zum n-leitenden Bereich relativ dünne p-Barriereschicht eingeprägt.

Gemäß zumindest einer Ausführungsform des optoelektronischen Halbleiterchips ist der optoelektronische Halbleiterchip auf ein p-leitendes Substrat aufgewachsen. Die Halbleiterschichten des Chips sind dabei bevorzugt im Ga-Face Wachstumsmodus auf das Substrat aufgewachsen. In dieser Ausführungsform kann auf den n-leitenden Bereich sowie den Tunnelkontakt verzichtet werden. Als p-leitendes Substrat kann zum Beispiel eines der folgenden Substrate Verwendung finden: p-dotiertes Galliumnitrid, p-Siliziumcarbid, p-Si (111).

Es ist dabei auch möglich, dass das p-leitende Substrat nach dem Aufwachsen der Schichtenfolge gedünnt wird. Das heißt, nach Aufwachsen der Halbleiterstruktur, die unter anderem den aktiven Bereich umfasst, kann die Dicke des p-leitenden Substrats reduziert werden oder das p-leitende Substrat wird vollständig entfernt. Der optoelektronische Halbleiterchip weist dann also ein gedünntes Substrat auf oder ist frei von einem Substrat.

Gemäß zumindest einer Ausführungsform des optoelektronischen Halbleiterchips umfasst der aktive Bereich zumindest eine Quantentopfstruktur. Bei der Quantentopfstruktur kann es sich um eine Mehrfachquantentopfstruktur oder besonders bevorzugt um eine Einfachquantentopfstruktur handeln. Dabei kann eine Quantisierung der Ladungsträger in der Quantentopfstruktur erfolgen, dies ist aber nicht zwingend erforderlich.

Gemäß zumindest einer Ausführungsform des optoelektronischen Halbleiterchips umfasst der aktive Bereich genau eine zur Strahlungserzeugung vorgesehene Einfachquantentopfstruktur. Das heißt, der aktive Bereich weist genau eine Einfachquantentopfstruktur auf, in der bei Betrieb des Halbleiterchips elektromagnetische Strahlung erzeugt wird.

Gemäß zumindest einer Ausführungsform ist der zur Strahlungserzeugung vorgesehenen Einfachquantentopfstruktur zumindest eine nicht zur Strahlungserzeugung vorgesehene Quantentopfstruktur vorgeordnet. Das heißt, diese optisch inaktive Quantentopfstruktur (pre-well) ist räumlich näher am Wachstumssubstrat angeordnet, als die optisch aktive Quantentopfstruktur.

Bevorzugt sind der optisch aktiven Quantentopfstruktur eine Mehrzahl von optisch inaktiven Quantentopfstrukturen in Wachstumsrichtung gesehen vorgeordnet. Beispielsweise sind der optisch aktiven Quantentopfstruktur drei bis fünf optisch inaktive Quantentopfstrukturen in Wachstumsrichtung gesehen vorgeordnet. Bei den optisch inaktiven Quantentopfstrukturen handelt es sich bevorzugt um Quantentopfstrukturen, die einen geringeren Indiumgehalt aufweisen, als die optisch aktive Quantentopfstruktur. Die optisch inaktiven Quantentopfstrukturen erzeugen im Betrieb des Halbleiterchips keine oder kaum elektromagnetische Strahlung. Sie können ein Übergitter für die optisch aktive Quantentopfstruktur ausbilden.

Der beschriebene optoelektronische Halbleiterchip macht sich dabei unter anderem die Erkenntnis zunutze, dass die beschriebenen, optisch inaktiven pre-wells die Qualität der optisch aktiven Quantentopfstruktur verbessern, da diese beispielsweise spannungsfreier aufwachsen können. Weiter hat sich gezeigt, dass die beschriebenen pre-well-Strukturen als Diffusionsbarrieren für einen p-Dotierstoff aus der p-dotierten Barriereschicht dienen. Bevorzugt sind die Pre-wells daher zwischen der p-dotierten Barriereschicht und dem optisch aktiven Quantentopf angeordnet.

Gemäß zumindest einer Ausführungsform ist zwischen p-dotierter Barriereschicht und dem aktiven Bereich eine Diffusionsbarriere angeordnet, die zum Beispiel ein Material aus dem III-V-Halbleitermaterialsystem AlₓGa₁₋ₓN enthält. Bevorzugt beträgt die Aluminiumkonzentration dabei wenigstens zwanzig Prozent. Eine solche Diffusionsbarriere kann auch alternativ zu den oben beschriebenen pre-wells als Barriere für den p-Dotierstoff aus der p-dotierten Barriereschicht vorgesehen sein. Bei dem p-Dotierstoff kann es sich beispielsweise um Magnesium handeln.

Gemäß zumindest einer Ausführungsform des optoelektronischen Halbleiterchips ist der Halbleiterchip auf ein Wachstumssubstrat aufgewachsen, das eine Fehlorientierung aufweist.

Dem beschriebenen optoelektronischen Halbleiterchip liegt dabei unter anderem die Erkenntnis zugrunde, dass auf einem fehlorientierten Wachstumssubstrat deutlich glattere Schichten aufwachsen, als auf einem exakt orientierten Substrat. Bevorzugt weist das Wachstumssubstrat eine Fehlorientierung (miscut-angle) zwischen 0,1 Grad und 1,0 Grad auf. Besonders bevorzugt beträgt die Fehlorientierung zwischen 0,2 Grad und 0,5 Grad. Bei dem Wachstumssubstrat kann es sich beispielsweise um eines der folgenden Wachstumssubstrate handeln: GaN, n-GaN, p-GaN, n-SiC, p-SiC, Saphir, n-Si(111), p-Si (111).

Gemäß zumindest einer Ausführungsform des optoelektronischen Halbleiterchips ist das Wachstumssubstrat, auf dem der Halbleiterchip aufgewachsen ist, gedünnt. Im Extremfall ist das Wachstumssubstrat von der auf das Substrat aufgewachsenen Schichtenfolge vollständig entfernt. Die Schichtenfolge ist dann frei von einem Substrat. Das Substrat kann dabei beispielsweise mittels Schleifen, Ätzen, Laserablation oder einer Kombination dieser Verfahren vom Wachstumssubstrat entfernt oder gedünnt sein.

Es wird ferner ein optoelektronisches Bauelement angegeben. Gemäß zumindest einer Ausführungsform weist das optoelektronische Bauelement zumindest einen optoelektronischen Halbleiterchip nach zumindest einer der oben beschriebenen Ausführungsformen auf. Bei dem optoelektronischen Bauelement handelt es sich bevorzugt um eine Lumineszenzdiode, also eine Leuchtdiode oder eine Laserdiode.

Gemäß zumindest einer Ausführungsform des optoelektronischen Bauelements enthält das optoelektronische Bauelement neben dem zumindest einen optoelektronischen Halbleiterchip Anschlüsse, über die das optoelektronische Halbleiterbauelement elektrisch kontaktierbar ist. Das heißt, beim Anlegen einer Spannung an die Anschlüsse des Bauelements wird in den optoelektronischen Halbleiterchip ein Strom eingeprägt. Der optoelektronische Halbleiterchip erzeugt dann elektromagnetische Strahlung.

Es wird ferner ein Verfahren zur Herstellung eines optoelektronischen Halbleiterchips nach zumindest einem der oben beschriebenen Ausführungsformen angegeben. Bei dem Verfahren werden folgende Bereiche in zeitlicher Reihenfolge auf einen Wafer abgeschieden: Eine p-dotierte Barriereschicht für einen aktiven Bereich des optoelektronischen Halbleiterchips, ein aktiver Bereich, der im Betrieb des Halbleiterchips zur Erzeugung elektromagnetischer Strahlung geeignet ist, wobei der aktive Bereich auf einem hexagonalen Verbindungshalbleiter basiert und eine n-dotierte Barriereschicht für den aktiven Bereich. Bei dem Wafer kann es sich um ein Aufwachssubstrat handeln, auf dem bereits weitere Bereiche des Halbleiterchips, wie beispielsweise ein p-leitender Bereich oder ein n-leitender Bereich abgeschieden sein können.

Gemäß zumindest einer Ausführungsform des Verfahrens zur Herstellung eines optoelektronischen Halbleiterchips werden folgende Bereiche in zeitlicher Reihenfolge auf einen Wafer abgeschieden: Eine p-dotierte Barriereschicht für einen aktiven Bereich des optoelektronischen Halbleiterchips, ein aktiver Bereich, der im Betrieb des Halbleiterchips zur Erzeugung elektromagnetischer Strahlung geeignet ist, wobei der aktive Bereich auf dem III-V-Halbleitermaterialsystem In_{y}Ga_{1-x-y}AlₓN mit 0 ≤ x ≤ 1, 0 ≤ y ≤ 1 und x + y ≤ 1 basiert und eine n-dotierte Barriereschicht für den aktiven Bereich. Bei dem Wafer kann es sich um ein Aufwachssubstrat handeln, auf dem bereits weitere Bereiche des Halbleiterchips, wie beispielsweise ein p-leitender Bereich oder ein n-leitender Bereich abgeschieden sein können.

Zudem ist es möglich, dass vor, zwischen oder nach den genannten Bereichen weitere Bereiche des optoelektronischen Halbleiterchips auf den Wafer abgeschieden werden. Die Bereiche des optoelektronischen Halbleiterchips werden vorzugsweise mittels eines der folgenden Epitaxieverfahren auf dem Wafer abgeschieden: metallorganische Gasphasenepitaxie (MOVPE), Molekularstrahlepitaxie (MBE), Hydridgasphasenepitaxie (HVPE). Die Abscheidung der Bereich erfolgt dabei bevorzugt in einem Ga-Face Wachstumsmodus.

Bei dem Aufwachssubstrat, auf dem die Bereiche des optoelektronischen Halbleiterchips abgeschieden werden, kann es sich sowohl um ein n-leitendes oder um ein p-leitendes Substrat handeln. Weiter kann das Aufwachssubstrat eine wie weiter oben beschrieben Fehlorientierung aufweisen.

Gemäß zumindest einer Ausführungsform des Verfahrens zur Herstellung eines optoelektronischen Halbleiterchips wird zunächst die p-dotierte Barriereschicht abgeschieden. Nachfolgend, das heißt, vor Abscheiden des aktiven Bereichs, wird der Wachstumsprozess unterbrochen und der Halbleiterwafer mit der aufgewachsenen p-dotierten Barriereschicht wird aus dem Wachstumsreaktor entfernt. Nachfolgend wird zum Beispiel die Belegung der Reaktorwände des Wachstumsreaktors neutralisiert. Das heißt, eventuell im Wachstumsreaktor verbleibender p-Dotierstoff wird entfernt. Daraufhin kann der Wafer mit der aufgewachsenen p-dotierten Barriereschicht wieder in den Reaktor eingeführt werden und das Wachstum kann wie oben beschrieben fortgesetzt werden. Auf diese Weise kann eine Verunreinigung des aktiven Bereichs mit dem p-Dotierstoff besonders effizient reduziert werden.

Dabei ist es aber auch möglich, dass das weitere Wachstum in einem anderen Wachstumsreaktor erfolgt als den Wachstumsreaktor, in dem die p-dotierte Barriereschicht abgeschieden wird.

Eine weitere Möglichkeit einen optoelektronischen Halbleiterchip herzustellen, bei dem piezoelektrische Felder im aktiven Bereich keine Barriere für die Injektion von Ladungsträgern darstellen, besteht darin die Struktur in der Molekularstrahlepitaxie oder in der metallorganischen Gasphasenepitaxie unter N-Überschuss zu realisieren. Dadurch lässt sich bei der Epitaxie eine N-Oberflächenterminierung einstellen, das heißt, die Struktur wird im N-Face Wachstumsmodus gewachsen. Dadurch ist die Polarisation der Piezofelder umgekehrt und die Struktur kann in der Reihenfolge n-Barriereschicht, aktiver Bereich, p-Barriereschicht gewachsen werden, ohne dass die beschriebenen ungünstigen Barrieren auftreten.

Weitere Vorteile, bevorzugte Ausführungsformen und Weiterbildungen des hier beschrieben Halbleiterchips sowie seiner Bestandteile ergeben sich aus den im Folgenden in Verbindung mit den Figuren erläuterten Ausführungsbeispielen.
Figur 1A zeigt eine schematische Schnittdarstellung eines hier beschriebenen Halbleiterchips.
Figur 1B zeigt eine schematische Schnittdarstellung eines hier beschriebenen optoelektronischen Halbleiterchips.
Figur 1C zeigt eine schematische Schnittdarstellung eines Ausführungsbeispiels des hier beschriebenen optoelektronischen Halbleiterchips.
Figur 2A zeigt eine schematische Schnittdarstellung eines hier beschriebenen optoelektronischen Halbleiterchips.
Figur 2B zeigt eine schematische Schnittdarstellung eines hier beschriebenen optoelektronischen Halbleiterchips.
Figur 2C zeigt eine schematische Schnittdarstellung eines Ausführungsbeispiels des hier beschriebenen optoelektronischen Halbleiterchips.
Figur 3 zeigt schematisch den Verlauf von Valenz- und Leitungsband für das erste Beispiel des hier beschriebenen optoelektronischen Halbleiterchips.
Figur 4 zeigt schematisch den Verlauf von Valenz- und Leitungsband für das vierte Beispiel des hier beschriebenen optoelektronischen Halbleiterchips.
Figur 5 zeigt schematisch den Verlauf von Valenz- und Leitungsband für einen optoelektronischen Halbleiterchip.
Figur 6 zeigt ein optoelektronisches Bauelement mit einem der optoelektronischen Halbleiterchips gemäß den Figuren 1 und 2.

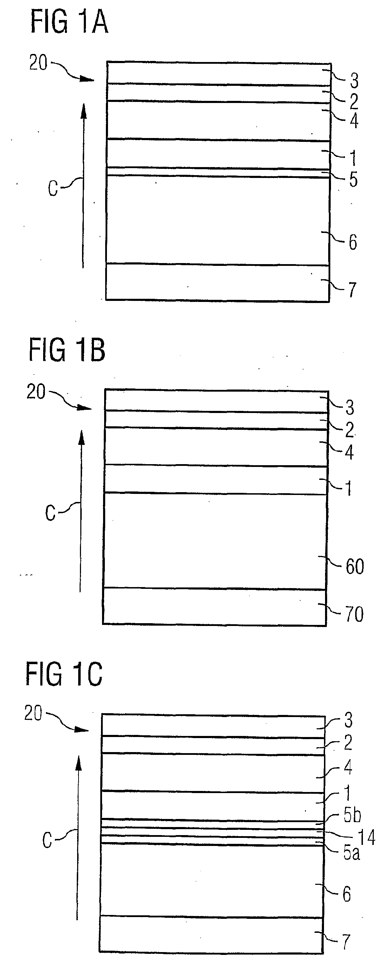

In den Beispielen und Figuren sind gleiche oder gleich wirkende Bestandteile jeweils mit den gleichen Bezugszeichen versehen. Die dargestellten Elemente der Figuren sind nicht notwendigerweise als maßstabsgerecht anzusehen, vielmehr können einzelne Bestandteile zum besseren Verständnis teilweise übertrieben groß dargestellt sein. Figur 1A zeigt eine schematische Schnittdarstellung eines hier beschriebenen optoelektronischen Halbleiterchips 20.

Als Aufwachssubstrat 7 dient in diesem Beispiel bevorzugt ein n-leitendes Substrat. Mögliche n-leitende Substrate sind dabei: n-GaN, n-SiC, n-Si (111). Es ist aber auch möglich, dass ein elektrisch nicht leitendes Substrat wie beispielsweise Saphir Verwendung findet.

Das Substrat 7 kann dabei eine leichte Fehlorientierung aufweisen, die sich hinsichtlich der Kristallqualität der aufwachsenden Schichten als vorteilhaft erweisen kann. Die Fehlorientierung des Substrats 7 beträgt bevorzugt zwischen 0,2 Grad und 0,5 Grad, zum Beispiel 0,3°. Eine solche Fehlorientierung führt zu deutlich glatteren Schichten mit vermindertem Inselwachstum und reduzierter Rauhigkeit. Die Rauhigkeit der aufwachsenden Schichten kann also dadurch reduziert sein.

Dem Substrat 7 folgt in Wachstumsrichtung c gesehen ein n-leitender Bereich 6 nach. Die Wachstumsrichtung ist dabei parallel zur kristallographischen c-Achse gewählt. Der Halbleiterchip 20 ist im Ga-face Wachstumsmodus gewachsen. Bei dem n-leitenden Bereich 6 handelt es sich bevorzugt um n-dotiertes Galliumnitrid. Die Schichtdicke für den n-leitenden Bereich beträgt circa 1 bis 5 *µ*m, bevorzugt zwischen 3 und 4 *µ*m. Bevorzugt ist der n-leitende Bereich mit einem Silizium dotiert.

Dem n-leitenden Bereich 6 folgt in Wachstumsrichtung c gesehen ein Tunnelkontakt 5 nach. Bei dem Tunnelkontakt 5 handelt es sich bevorzugt um einen hochdotierten n-p-Tunnelübergang. Dabei ist die n-dotierte Seite dem n-leitenden Bereich 6 zugewandt. Die p-dotierte Seite ist dem n-leitenden Bereich 6 abgewandt. Der Tunnelkontakt 5 umfasst auf seiner, dem n-leitenden Bereich 6 zugewandten Seite, eine hoch n-dotierte In_{y}Ga_{1-x-y}AlₓN Schicht mit 0 ≤ x ≤ 1, 0 ≤ y ≤ 1 und x + y ≤ 1 beziehungsweise ein hoch n-dotiertes In_{y}Ga_{1-x-y}AlₓN Übergitter mit 0 ≤ x ≤ 1, 0 ≤ y ≤ 1 und x + y ≤ 1. Als n-Dotierstoff eignet sich beispielsweise Silizium. Die Dotierkonzentration beträgt bevorzugt wenigstens 10¹⁹, besonders bevorzugt wenigstens 10²⁰. Die hoch n-dotierte Schicht ist bevorzugt höchstens 20nm dick.

Auf der dem n-leitenden Bereich 6 abgewandten Seite umfasst der Tunnelkontakt 5 beispielsweise eine hoch p-dotierte In_{y}Ga_{1-x-y}AlₓN Schicht mit 0 ≤ x ≤ 1, 0 ≤ y ≤ 1 und x + y ≤ 1 oder ein hoch p-dotiertes In_{y}Ga_{1-x-y}AlₓN Übergitter mit 0 ≤ x ≤ 1, 0 ≤ y ≤ 1 und x + y ≤ 1. Ein möglicher p-Dotierstoff ist dabei durch Magnesium gegeben. Die Dotierkonzentration beträgt bevorzugt wenigstens 10¹⁹, besonders bevorzugt wenigstens 10²⁰. Die hoch p-dotierte Schicht ist bevorzugt höchstens 20nm dick.

Dem Tunnelkontakt 5 folgt in Wachstumsrichtung c die p-Barriereschicht 1 nach. Bei der p-Barriereschicht 1 handelt es sich zum Beispiel um eine p-dotierte AlₓGa₁₋ₓN-Schicht mit 0 < x ≤ 0,1. Die Schichtdicke der p-Barriereschicht beträgt bevorzugt zwischen 50 und 500 Nanometer. Ein bevorzugter p-Dotierstoff ist dabei Magnesium. Die Barriereschicht 1 dient als p-Barriereschicht für den aktiven Bereich 2.

Der Tunnelkontakt 5 zwischen n-leitenden Bereich 6 und p-Barriereschicht 1 ermöglicht es, dass der Stromtransport im Halbleiterchip 20 weitestgehend im n-leitenden Bereich erfolgt. Dadurch werden ohmsche Verluste im Betrieb des Chips minimiert. Eine gewisse Dicke der p-Barriereschicht 1 nach dem Tunnelkontakt 5 ist erforderlich, um eine gute Kristallqualität für den nachfolgenden aktiven Bereich 1 des Halbleiterchips 20 zu erhalten.

Bevorzugt folgt der p-dotierten Barriereschicht 1 eine Diffusionsbarriere 4 nach. Die Diffusionsbarriere 4 ist bevorzugt geeignet, eine Kontamination des aktiven Bereichs 2 mit dem p-Dotierstoff - das heißt, zum Beispiel mit Magnesium - zu reduzieren oder zu verhindern. Die Kontamination erfolgt ohne Diffusionsbarriere 4 durch Diffusion von p-Dotierstoff beispielsweise aus der p-dotierten Barriereschicht 1 in den aktiven Bereich 2. Im Beispiel der Figur 1A umfasst die Diffusionsbarriere 4 beispielsweise eine AlₓGa₁₋ₓN-Zwischenschicht. Die Diffusionsbarriere 4 ist bevorzugt zwischen 1 und 20nm dick. Die Aluminiumkonzentration beträgt bevorzugt höchstens 50 Prozent.

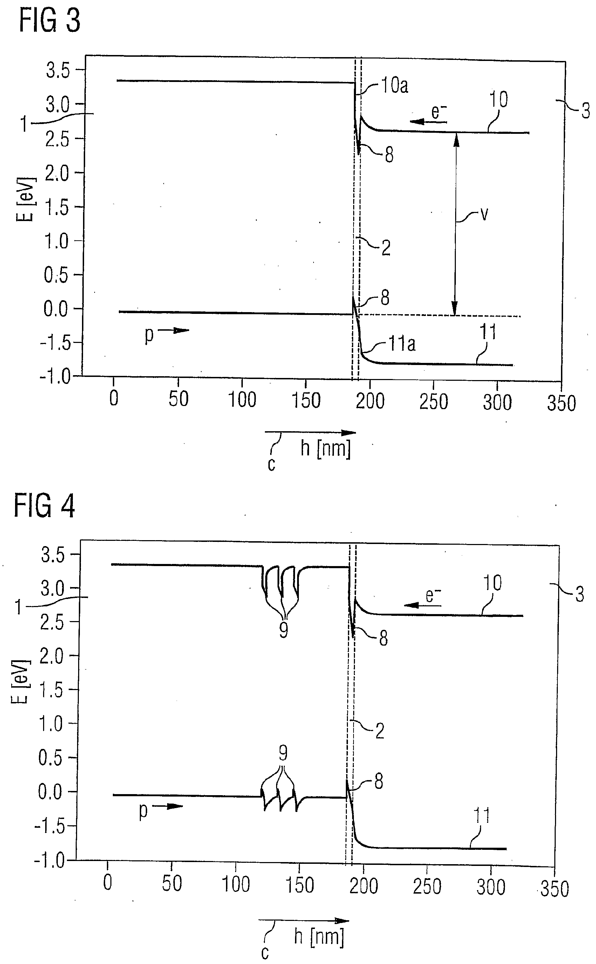

Der Diffusionsbarriere 4 ist in Wachstumsrichtung c gesehen der aktive Bereich 2 nachgeordnet. Im Beispiel der Figur 1A umfasst der aktive Bereich bevorzugt genau eine zur Strahlungserzeugung vorgesehene Einfachquantentopfstruktur 8 (siehe dazu auch Figur 3). Der aktive Bereich 2 basiert bevorzugt auf dem III-V-Halbleitermaterialsystem In_{y}Ga_{1-y}N mit 0 < y ≤ 1. Bevorzugt ist der aktive Bereich 2 zur Erzeugung von elektromagnetischer Strahlung in ultravioletten, blauen, blau-grünen, gelben oder roten Spektralbereich geeignet. Die Indiumkonzentration im aktiven Bereich 2 beträgt bevorzugt zwischen 10 und 60 Prozent.

Dem aktiven Bereich 2 folgt in Wachstumsrichtung c gesehen eine n-dotierte Barriereschicht 3 nach. Bei der n-dotierten Barriereschicht 3 handelt es sich beispielsweise um eine mit Silizium dotierte Galliumnitridschicht. Die Dicke der n-dotierten Barriereschicht 3 beträgt bevorzugt zwischen 100 und 200 nm.

Im Übrigen kann der Halbleiterchip 20 gemäß der Figur 1A weitere Schichten und Bereich umfassen, die in der Figur 1A nicht dargestellt sind. So kann der Halbleiterchip zum Beispiel Kontaktschichten auf der Unterseite des Substrats 7 und auf der Oberseite der Barriereschicht 3 aufweisen. Weiter ist es möglich, dass das Substrat 7 gedünnt oder vollständig entfernt ist. Der Halbleiterchip 20 kann dann zum Beispiel mit seiner dem Substrat 7 abgewandten Oberfläche auf einem Träger befestigt sein, der bezüglich seines thermischen Ausdehnungskoeffizienten besser an die aufgewachsenen Schichten angepasst sein kann, als das ursprünglich Aufwachssubstrat 7.

Der Halbleiterchip 20 ist bevorzugt mittels eines der folgenden Epitaxieverfahren hergestellt: metallorganische Gasphasenepitaxie, Molekularstrahlepitaxie,
Hydridgasphasenepitaxie. Bevorzugt ist der Halbleiterchip im Ga-Face Wachstumsmodus in Richtung parallel zur kristallographischen c-Achse gewachsen.
Weiter ist es möglich, dass der Halbleiterchip 20, wie in Figur 1B dargestellt, ein p-leitendes Aufwachssubstrat 70 aufweist. In diesem Fall kann der n-leitende Bereich 6 des Beispiels der Figur 1A durch einen p-leitenden Bereich 60 ersetzt sein. Der Tunnelkontakt 5 kann entfallen. Mögliche p-leitende Substrate sind dabei beispielsweise: p-GaN, p-SiC, p-Si (111).

Abweichend vom Beispiel der Figur 1A zeigt Figur 1C einen Halbleiterchip 20, bei dem zwischen der hoch n-dotierten Schicht 5a des Tunnelkontakts 5 und der hoch p-dotierten Schicht 5b des Tunnelkontakts 5 eine Diffusionsbarriere 14 angeordnet ist. Die Diffusionsbarriere 14 ist bevorzugt geeignet, eine Diffusion des p-Dotierstoffs aus der hoch p- in die hoch n-dotierte Schicht zu hemmen oder zu verhindern. Bevorzugt handelt es sich bei der Diffusionsbarriere 14 um eine AlₓGa₁₋ₓN Schicht mit einer Aluminiumkonzentration von wenigsten 50 Prozent, bevorzugt wenigsten 60 Prozent, besonders bevorzugt wenigstens 80 Prozent. Die Schichtdicke der Diffusionsbarriere 14 beträgt bevorzugt zwischen 1 und 2 nm.

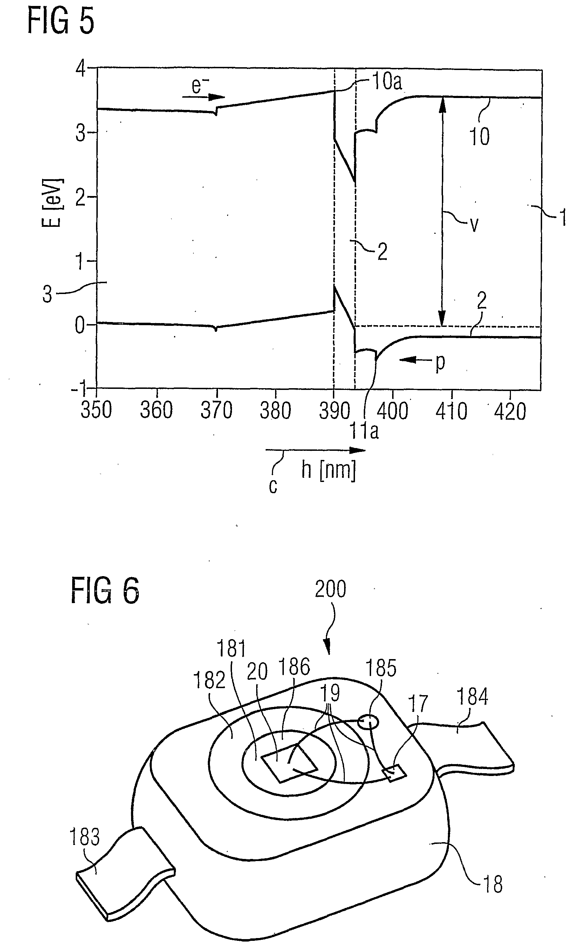

Figur 3 zeigt schematisch den Verlauf des Leitungsbandes 10 und den Verlauf des Valenzbandes 11 in Abhängigkeit von der Wachstumshöhe h für einen Halbleiterchip 20 gemäß dem Beispiel der Figur 1a. Figur 5 zeigt im Gegensatz dazu den Verlauf des Leitungsbandes 10 und des Valenzbandes 11 in Abhängigkeit von der Wachstumshöhe h für einen Halbleiterchip, bei dem in Wachstumsrichtung gesehen eine n-leitende Barriereschicht 3, ein aktiver Bereich 2 und eine p-Barriereschicht 1 abfolgen. Wie der Figur 5 zu entnehmen ist, führt die Polung der im allgemeinen Teil der Beschreibung beschriebenen piezoelektrischen Felder zu einer Barriere 10a für die Injektion von Elektronen e, die aus dem n-dotierten Bereich 3 kommen. Die Elektronen e müssen die Energiebarriere 10a überwinden, um im Einfachquantentopf 8 eingefangen zu werden. Ein Teil der Elektronen e, die diese Barriere 10a überwinden, wird nicht vom Quantentopf 8 eingefangen, sondern folgt dem weiteren Verlauf des Leitungsbandes. Diese Elektronen e stehen daher nicht zur Strahlungserzeugung zur Verfügung. Wird die Betriebsspannung, die am Halbleiterchip anliegt, erhöht, so erhöht sich der Anteil der Ladungsträger, die nicht vom Quantentopf 8 eingefangen werden. Als Resultat fällt die interne Quanteneffizienz des Halbleiterchips mit wachsender Stromdichte stark ab.

Für die Löcher p im Valenzband 11 gilt ähnliches. Sie müssen die Energiebarriere 11a überwinden, um im Quantentopf 8 eingefangen zu werden.

Dem hier vorgeschlagenen Halbleiterchip 20 liegt nun unter anderem die Erkenntnis zugrunde, dass sich die zunächst als negativ erscheinenden piezoelektrischen Felder im aktiven Bereich 2 des Halbleiterchips 20 zur Verbesserung des Ladungsträgereinfangs einer Quantentopfstruktur nutzbar machen lassen.

Wie in Figur 3 dazu ersichtlich, führt die Änderung der Schichtabfolge zu p-Barriereschicht 1, aktiver Bereich 2 und n-Barriereschicht 3 in Wachstumsrichtung c dazu, dass die Energiebarrieren 10a und 11a für Elektronen e beziehungsweise Löcher p den Einfang von Ladungsträgern in der Quantentopfstruktur 8 stark verbessern. Diese Barrieren sind der Quantentopfstruktur 8 nun in der jeweiligen Flussrichtung der Ladungsträger (angedeutet durch Pfeile) nachgeordnet. Die Abhängigkeit der Quanteneffizienz von der Stromdichte ist dadurch stark reduziert oder besteht gar nicht mehr. Die Strahlleistung eines solchen Halbleiterchips ist über große Bereiche der Stromstärke direkt proportional zum eingeprägten Strom. Die verbesserte Quanteneffizienz erlaubt bei kleinerer Chipfläche eine größere Lichtleistung ohne an Effizienz des Chips zu verlieren. Weiter führt die beschriebene Änderung der Schichtabfolge zu einer deutlichen Absenkung der Betriebsspannung V des Halbleiterchips 20.
Wie Figur 3 weiter verdeutlicht, ergibt sich der beschriebene Vorteil insbesondere für Einfachquantentopfstrukturen 8. In den Einfachquantentopfstrukturen 8 in Wachstumsrichtung c gesehen vorgeordneten Quantentopfstrukturen würde kaum Injektion von Ladungsträgern erfolgen, da zunächst die Barrieren 10a, 11a zu überwinden wären.

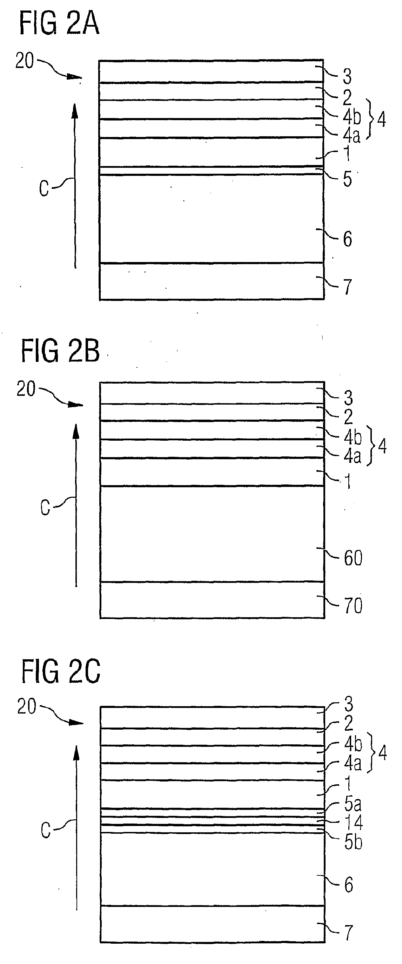

Figur 2A zeigt ein zweites Beispiel des hier beschriebenen optoelektronischen Halbleiterchips 20. Abweichend vom Beispiel der Figur 1A ist in diesem Beispiel die Diffusionsbarriere 4 durch zwei Schichten 4a und 4b gegeben. Bei der Schicht 4a handelt es sich um eine In_{y}Ga_{1-y}N-Schicht, die nicht zur Strahlungserzeugung vorgesehene Quantentopfstruktur 9 umfasst. Die Schicht 4b kann zum Beispiel durch eine intrinsische Galliumnitridschicht gegeben sein.
Figur 4 zeigt schematisch das Leitungsband 10 und das Valenzband 11 in Abhängigkeit von der Wachstumshöhe h für den in Figur 2A dargestellten Halbleiterchip 20. Dem Einfachquantentopf 8 sind dabei drei weniger tiefe Quantentöpfe 9 in Wachstumsrichtung gesehen vorgeordnet, die nicht zur Strahlungserzeugung vorgesehen sind. Diese Quantentopfstrukturen 9 basieren beispielsweise auf dem III-V-Halbleitermaterialsystem In_{y}Ga_{1-x-y}AlₓN mit einem Indiumanteil von höchstens 10 Prozent. Dagegen beträgt der Indiumanteil im optisch aktiven Quantentopf 8 bevorzugt zwischen 10 und 60 Prozent.
Dem Halbleiterchip 20 der Figur 2A liegt dabei unter anderem die Erkenntnis zugrunde, dass die optisch inaktiven Quantentopfstrukturen 9 zum einen die Diffusion eines p-Dotierstoffes wie beispielsweise Magnesium hemmen. Zum anderen bilden die Quantentopfstrukturen 9 ein Übergitter für die Einfachquantentopfstruktur 8 und verbessern damit die Kristallstruktur für den aktiven Bereich 2.

Figur 2B zeigt abweichend vom Beispiel der Figur 2A einen optoelektronischen Chip 20, bei dem die Schichtfolgen auf ein p-leitendes Substrat 70 abgeschieden sind. Der n-leitende Bereich 6 ist hierbei durch einen p-leitenden Bereich 60 ersetzt, der Tunnelkontakt 5 kann entfallen.

Abweichend vom Beispiel der Figur 2A zeigt Figur 2C einen Halbleiterchip 20, bei dem zwischen der hoch n-dotierten Schicht 5a des Tunnelkontakts 5 und der hoch p-dotierten Schicht 5b des Tunnelkontakts 5 eine Diffusionsbarriere 14 angeordnet ist. Die Diffusionsbarriere 14 ist bevorzugt geeignet eine Diffusion des p-Dotierstoffs aus der hoch p- in die hoch n-dotierte Schicht zu hemmen oder zu verhindern. Bevorzugt handelt es sich bei der Diffusionsbarriere 14 um eine AlₓGa₁₋ₓN Schicht, die eine Aluminiumkonzentration von wenigsten 50 Prozent, bevorzugt wenigsten 60 Prozent, besonders bevorzugt wenigstens 80 Prozent aufweist. Die Schichtdicke der Diffusionsbarriere 14 beträgt bevorzugt zwischen 1 und 2 nm.

Figur 6 zeigt ein optoelektronisches Bauelement 200. Bei dem optoelektronischen Bauelement 200 handelt es sich vorzugsweise um eine Lumineszenzdiode. Bei dem Halbleiterchip 20 handelt es sich folglich um einen Lumineszenzdiodenchip. Der Halbleiterchip 20 ist durch einen in Zusammenhang mit den Figuren 1 und 2 beschriebenen Halbleiterchip gegeben. Er ist beispielsweise in die Ausnehmung eines Gehäuses 18 angeordnet.

Das Gehäuse 18 ist zum Beispiel aus einem Kunststoff oder einem keramischen Material gebildet. Der Chip ist mit einer seiner Oberflächen elektrisch leitend mit dem äußeren Anschlussteil 183 verbunden. Beispielsweise kann der Chip dazu auf das Anschlussteil 183, das in der Ausnehmung des Gehäuses 18 frei liegt, gebondet sein. Der Halbleiterchip 20 ist weiter mit dem äußeren Anschlussteil 184 verbunden. Beispielsweise ist der Halbleiterchip 20 durch einen Wire-Bonddraht 19 mit dem Anschlussteil 184 elektrisch leitend verbunden. Dazu kann das Gehäuse 18 beispielsweise eine weitere Ausnehmung 185 aufweisen, in der das zweite Anschlussteil 184 frei zugänglich ist.

Dem Chip 20 ist ferner ein Reflektor 182 nachgeordnet, der durch einen Teil des Gehäuses gebildet sein kann. Weiter ist dem Halbleiterchip 20 ein Element 17 zum Schutz des Halbleiterchips 20 gegen Überspannungen, beispielsweise gegen ESD (Electro Static Discharge)-Spannungspulse parallel oder antiparallel geschaltet. Bei dem Element 17 kann es sich zum Beispiel um eine Leuchtdiode, eine Zener-Diode oder einen Varistor handeln.

Der Chip 20 ist ferner vorzugsweise von einer Vergussmasse 186 umgeben, die zum Beispiel Silikon, Epoxidharz oder PMMA enthalten kann. Weiter kann die Vergussmasse 186 ein Lumineszenzkonversionsmaterial enthalten, das geeignet ist, zumindest einen Teil der vom Lumineszenzdiodenchipchip 20 im Betrieb erzeugten elektromagnetischen Strahlung Wellenlängen zu konvertieren. Auf diese Weise kann unter anderem weißes Licht erzeugt werden. Geeignete Lumineszenz-Konversionsmaterialien, wie etwa ein YAG:Ce Pulver, sind z.B. in der Druckschrift WO98/12757 beschrieben.

## Patentansprüche

1. Optoelektronischer Halbleiterchip mit folgender Abfolge von Bereichen in einer Wachstumsrichtung (c) des Halbleiterchips (20):
- eine p-dotierte Barriereschicht (1) für einen aktiven Bereich (2),
- der aktive Bereich (2), der zur Erzeugung elektromagnetischer Strahlung geeignet ist, wobei der aktive Bereich auf einem hexagonalen Verbindungshalbleiter basiert, und
- eine n-dotierte Barriereschicht (3) für den aktiven Bereich (2), wobei
- der aktive Bereich auf dem III-V-Halbleiter-Materialsystem InyGa_{1-x-y} AlₓN mit 0 ≤ x ≤ 1, 0 ≤ y ≤ 1 und x + y ≤ 1 basiert,
- in Wachstumsrichtung (c) gesehen der p-dotierten Barriereschicht (1) ein Tunnelkontakt (5) vorgeordnet ist, **dadurch gekennzeichnet, dass**
- der Tunnelkontakt (5) einen hoch n-dotierten Bereich (5a) und einen hoch p-dotierten Bereich (5b), der mit einem p-Dotierstoff dotiert ist, aufweist,
- der Tunnelkontakt (5) eine Diffusionsbarriere (14) zwischen den beiden Bereichen (5a,5b) des Tunnelkontakts (5) aufweist,
- die Diffusionsbarriere (14) dazu geeignet ist, eine Diffusion des p-Dotierstoffs in den hoch n-dotierten Bereich (5b) des Tunnelkontakts (5) zu hemmen oder zu verhindern,
- die Diffusionsbarriere (14) eine AlₓGa₁₋ₓN Schicht mit einer Aluminiumkonzentration x von wenigstens 60 Prozent ist.

2. Optoelektronischer Halbleiterchip nach dem vorherigen Anspruch,
bei dem die Schichtdicke der Diffusionsbarriere (14) zwischen 1 und 2 nm beträgt.

3. Optoelektronischer Halbleiterchip nach einem der vorherigen Ansprüche,
bei dem zwischen p-dotierter Barriereschicht (1) und dem aktiven Bereich (2) eine Diffusionsbarriere (4) angeordnet ist, die geeignet ist, die Diffusion eines Dotierstoffes in den aktiven Bereich (2) zu behindern.

4. Optoelektronischer Halbleiterchip nach einem der vorherigen Ansprüche,
bei dem in Wachstumsrichtung (c) gesehen dem Tunnelkontakt (5) ein n-leitender Bereich(6) vorgeordnet ist.

5. Optoelektronischer Halbleiterchip nach einem der vorherigen Ansprüche,
bei dem der aktive Bereich (2) eine Quantentopfstruktur (8, 9) umfasst.

6. Optoelektronischer Halbleiterchip nach einem der vorherigen Ansprüche,
bei dem der aktive Bereich (2) genau eine zur Strahlungserzeugung vorgesehene Einfachquantentopfstruktur (8) umfasst.

7. Optoelektronischer Halbleiterchip nach einem der vorherigen Ansprüche,
bei dem der zur Strahlungserzeugung vorgesehenen Quantentopfstruktur (2) in Wachstumsrichtung (c) gesehen zumindest eine nicht zur Strahlungserzeugung vorgesehene Quantentopfstruktur (9) vorgeordnet ist.

8. Optoelektronischer Halbleiterchip nach Anspruch 7,
bei dem die nicht zur Strahlungserzeugung vorgesehene Quantentopfstruktur (9) eine geringere Indiumkonzentration aufweist, als die zur Strahlungserzeugung vorgesehene Quantentopfstruktur (8).

9. Optoelektronischer Halbleiterchip nach einem der vorherigen Ansprüche,
bei dem zwischen p- dotierter Barriereschicht (1) und aktivem Bereich (2) eine Diffusionsbarriere (4) angeordnet ist, die ein Material aus dem III-V-Halbleiter-Materialsystem AlₓGa₁₋ₓN enthält mit x ≤ 0,2.

10. Optoelektronischer Halbleiterchip nach einem der vorherigen Ansprüche,
bei dem der aktive Bereich (2) auf dem III-V-Halbleiter-Materialsystem In_{y}Ga_{1-y}N mit 0 < y ≤ 1 basiert.

11. Optoelektronischer Halbleiterchip nach einem der vorherigen Ansprüche,
aufweisend ein Wachstumssubstrat (7), das eine Fehlorientierung aufweist.

12. Optoelektronischer Halbleiterchip nach dem vorherigen Anspruch,
bei dem die Fehlorientierung des Wachstumssubstrats (7) zwischen 0,1° und 1,0° beträgt.

13. Optoelektronischer Halbleiterchip nach einem der vorherigen Ansprüche,
bei dem das Wachstumssubstrat (7) gedünnt ist.

14. Optoelektronischer Halbleiterchip nach einem der Ansprüche 2 bis 13,
bei dem der Halbleiterchip im Ga-face Wachstumsmodus gewachsen ist.

15. Optoelektronisches Bauelement,
mit einem optoelektronischen Halbleiterchip nach zumindest einem der vorherigen Ansprüche,
aufweisend Anschlüsse (183, 184), über die der optoelektronische Halbleiterchip (20) elektrisch kontaktierbar ist.

16. Verfahren zur Herstellung eines optoelektronischen Halbleiterchips mit folgender Abfolge von Bereichen in einer Wachstumsrichtung (c) des Halbleiterchips (20):
- eine p-dotierte Barriereschicht (1) für einen aktiven Bereich (2),
- der aktive Bereich (2), der zur Erzeugung elektromagnetischer Strahlung geeignet ist, wobei der aktive Bereich auf einem hexagonalen Verbindungshalbleiter basiert, und
- eine n-dotierte Barriereschicht (3) für den aktiven Bereich (2), wobei
- der aktive Bereich auf dem III-V-Halbleiter-Materialsystem In_{y}Ga_{1-x-y}AlₓN mit 0 ≤ x ≤ 1, 0 ≤ y ≤ 1 und x + y ≤ 1 basiert,
- in Wachstumsrichtung (c) gesehen der p-dotierten Barriereschicht (1) ein Tunnelkontakt (5) vorgeordnet ist,
- der Tunnelkontakt (5) einen hoch n-dotierten Bereich (5a) und einen hoch p-dotierten Bereich (5b), der mit einem p-Dotierstoff dotiert ist, aufweist,
- der Tunnelkontakt (5) eine Diffusionsbarriere (14) zwischen den beiden Bereichen (5a,5b) des Tunnelkontakts (5) aufweist,
- die Diffusionsbarriere (14) dazu geeignet ist, eine Diffusion des p-Dotierstoffs in den hoch n-dotierten Bereich (5b) des Tunnelkontakts (5) zu hemmen oder zu verhindern,
- die Diffusionsbarriere (14) eine AlxGa1-xN Schicht mit einer Aluminiumkonzentration x von wenigstens 60 Prozent ist, wobei die folgenden Bereiche in der genannten Reihenfolge auf einen Wafer abgeschieden werden:
a) die p-dotierte Barriereschicht (1) für den aktiven Bereich (2) des Halbleiterchips,
b) der aktive Bereich (2),
c) die n-dotierte Barriereschicht (3) für den aktiven Bereich (2).

17. Verfahren nach Anspruch 16,
wobei eines der folgenden Epitaxieverfahren Verwendung findet: Metallorganische Gasphasenepitaxie, Molekularstrahlepitaxie, Hydridgasphasenepitaxie.

18. Verfahren nach einem der Ansprüche 16 oder 17,
wobei der Halbleiterchip im Ga-face Wachstumsmodus gewachsen wird.

## Claims

1. Optoelectronic semiconductor chip comprising the following sequence of regions in a growth direction (c) of the semiconductor chip (20):
- a p-doped barrier layer (1) for an active region (2),
- the active region (2), which is suitable for generating electromagnetic radiation, wherein the active region is based on a hexagonal compound semiconductor, and
- an n-doped barrier layer (3) for the active region (2), wherein
- the active region is based on the III-V semiconductor material system In_{y}Ga_{1-x-y}AlₓN where 0 ≤ x ≤ 1, 0 ≤ y ≤ 1 and x + y ≤ 1,
- a tunnel contact (5) is disposed upstream of the p-doped barrier layer (1) as seen in growth direction (c),
**characterized in that**
- the tunnel contact (5) has a highly n-doped region (5a) and a highly p-doped region (5b) doped with a p-dopant,
- the tunnel contact (5) has a diffusion barrier (14) between the two regions (5a, 5b) of the tunnel contact (5),
- the diffusion barrier (14) is suitable for impeding or preventing a diffusion of the p-dopant into the highly n-doped region (5b) of the tunnel contact (5),
- the diffusion barrier (14) is an AlₓGa₁₋ₓN layer having an aluminium concentration x of at least 60 per cent.

2. Optoelectronic semiconductor chip according to the preceding claim,
wherein the layer thickness of the diffusion barrier (14) is between 1 and 2 nm.

3. Optoelectronic semiconductor chip according to one of the preceding claims,
in which a diffusion barrier (4) is arranged between p-doped barrier layer (1) and the active region (2), said diffusion barrier being suitable for impeding the diffusion of a dopant into the active region (2).

4. Optoelectronic semiconductor chip according to one of the preceding claims,
in which an n-conducting region (6) is disposed upstream of the tunnel contact (5) as seen in growth direction (c).

5. Optoelectronic semiconductor chip according to one of the preceding claims,
in which the active region (2) comprises a quantum well structure (8, 9).

6. Optoelectronic semiconductor chip according to one of the preceding claims,
in which the active region (2) comprises precisely one single quantum well structure (8) provided for generating radiation.

7. Optoelectronic semiconductor chip according to one of the preceding claims,
in which at least one quantum well structure (9) which is not provided for generating radiation is disposed upstream of the quantum well structure (2) provided for generating radiation, as seen in growth direction (c).

8. Optoelectronic semiconductor chip according to Claim 7,
in which the quantum well structure (9) which is not provided for generating radiation has a lower indium concentration than the quantum well structure (8) provided for generating radiation.

9. Optoelectronic semiconductor chip according to one of the preceding claims,
in which a diffusion barrier (4) containing a material from the III-V semiconductor material system AlₓGa₁₋ₓN, where x ≤ 0.2, is arranged between p-doped barrier layer (1) and active region (2).

10. Optoelectronic semiconductor chip according to one of the preceding claims,
in which the active region (2) is based on the III-V semiconductor material system In_{y}Ga_{1-y}N where 0 < y ≤ 1.

11. Optoelectronic semiconductor chip according to one of the preceding claims,
having a growth substrate (7) having a misorientation.

12. Optoelectronic semiconductor chip according to one of the preceding claims,
in which the misorientation of the growth substrate (7) is between 0.1° and 1.0°.

13. Optoelectronic semiconductor chip according to one of the preceding claims,
in which the growth substrate (7) is thinned.

14. Optoelectronic semiconductor chip according to one of Claims 2 to 13,
in which the semiconductor chip is grown in the GA-face growth mode.

15. Optoelectronic component,
comprising an optoelectronic semiconductor chip according to at least one of the preceding claims, having connections (183, 184) via which electrical contact can be made with the optoelectronic semiconductor chip (20).

16. Method for producing an optoelectronic semiconductor chip comprising the following sequence of regions in a growth direction (c) of the semiconductor chip (20):
- a p-doped barrier layer (1) for an active region (2),
- the active region (2), which is suitable for generating electromagnetic radiation, the active region being based on a hexagonal compound semiconductor, and
- an n-doped barrier layer (3) for the active region (2), wherein
- the active region (2) is based on the III-V semiconductor material system In_{y}Ga_{1-x-y}AlₓN where 0 ≤ x ≤ 1, 0 ≤ y ≤ 1 and x + y ≤ 1,
- a tunnel contact (5) is disposed upstream of the p-doped barrier layer (1) as seen in growth direction (c),
- the tunnel contact (5) has a highly n-doped region (5a) and a highly p-doped region (5b) doped with a p-dopant,
- the tunnel contact (5) has a diffusion barrier (14) between the two regions (5a, 5b) of the tunnel contact (5),
- the diffusion barrier (14) is suitable for inhibiting or preventing a diffusion of the p-dopant into the highly n-doped region (5b) of the tunnel contact (5),
- the diffusion barrier (14) is an AlₓGa₁₋ₓN layer having an aluminium concentration x of at least 60 per cent,
wherein the following regions are deposited in the stated order onto a wafer:
a) the p-doped barrier layer (1) for the active region (2) of the semiconductor chip,
b) the active region (2),
c) the n-doped barrier layer (3) for the active region (2).

17. Method according to Claim 16,
one of the following epitaxy methods being used: metal organic vapor phase epitaxy, molecular beam epitaxy, hybrid vapor phase epitaxy.

18. Method according to Claims 16 or 17,
the semiconductor chip being grown in the Ga-face growth mode.

## Revendications

1. Puce semi-conductrice optoélectronique comportant la série suivante de régions dans une direction de croissance (c) de la puce semi-conductrice (20) :
- une couche barrière dopée p (1) pour une région active (2),
- la région active (2), qui est apte à générer un rayonnement électromagnétique et est à base d'un semi-conducteur à composé hexagonal, et
- une couche barrière dopée n (3) pour la région active (2), dans laquelle
- la région active est à base d'un système de matériau semi-conducteur III-V d'In_{y}Ga_{1-x-y}AlₓN, avec 0 ≤ x ≤ 1, 0 ≤ y ≤ 1 et x + y ≤ 1,
- lorsqu'elle est vue dans la direction de croissance (c), la couche barrière dopée p (1) est disposée en amont d'un contact tunnel (5), **caractérisée en ce que**
- le contact tunnel (5) comporte une région à fort dopage n (5a) et une région à fort dopage p (5b) qui est dopée par un matériau de dopage p,
- le contact tunnel (5) comporte une barrière de diffusion (14) entre les deux régions (5a, 5b) du contact tunnel (5),
- la barrière de diffusion (14) est apte à augmenter ou réduire une diffusion du matériau de dopage p dans la région à fort dopage n (5b) du contact tunnel (5),
- la barrière de diffusion (14) est une couche d'AlₓGa₁₋ₓN ayant une concentration en aluminium x au moins à 60 pour cent.

2. Puce semi-conductrice optoélectronique selon la revendication précédente,
dans laquelle l'épaisseur de couche de la barrière de diffusion (14) est comprise entre 1 et 2 nm.

3. Puce semi-conductrice optoélectronique selon l'une quelconque des revendications précédentes,
dans laquelle il est prévu entre la couche barrière dopée p (1) et la région active (2) une barrière de diffusion (4) qui est apte à empêcher la diffusion d'un matériau dopant dans la région active (2).

4. Puce semi-conductrice optoélectronique selon l'une quelconque des revendications précédentes,
dans laquelle, lorsqu'on l'observe dans la direction de croissance (c), une région à conductivité de type n (6) est disposée en amont du contact tunnel (5).

5. Puce semi-conductrice optoélectronique selon l'une quelconque des revendications précédentes,
dans laquelle la région active (2) comprend une structure de puits quantique (8, 9).

6. Puce semi-conductrice optoélectronique selon l'une quelconque des revendications précédentes,
dans laquelle la région active (2) comprend exactement une structure de puits quantique simple (8) prévue pour générer un rayonnement.

7. Puce semi-conductrice optoélectronique selon l'une quelconque des revendications précédentes,
dans laquelle, lorsqu'on l'observe dans la direction de croissance (c), au moins une structure de puits quantique (9) non prévue pour générer un rayonnement est disposée en amont de la structure de puits quantique (2) prévue pour générer un rayonnement.

8. Puce semi-conductrice optoélectronique selon la revendication 7,
dans laquelle la structure de puits quantique (9) non prévue pour générer un rayonnement présente une plus faible concentration en indium que la structure de puits quantique (8) prévue pour générer un rayonnement.

9. Puce semi-conductrice optoélectronique selon l'une quelconque des revendications précédentes,
dans laquelle, entre la couche barrière dopée p (1) et la région active (2), il est disposé une barrière de diffusion (4) qui contient un matériau du système de matériau semi-conducteur III-V d'AlₓGa₁₋ₓN, avec x ≥ 0,2.

10. Puce semi-conductrice optoélectronique selon l'une quelconque des revendications précédentes,
dans laquelle la région active (2) est à base d'un système de matériau semi-conducteur III-V d'In_{y}Ga_{1-y}N-avec 0 < y ≤ 1.

11. Puce semi-conductrice optoélectronique selon l'une quelconque des revendications précédentes, comportant un substrat de croissance (7) qui présente un défaut d'orientation.

12. Puce semi-conductrice optoélectronique selon la revendication précédente,
dans laquelle le défaut d'orientation du substrat de croissance (7) est compris entre 0,1° et 1,0°.

13. Puce semi-conductrice optoélectronique selon l'une quelconque des revendications précédentes,
dans laquelle le substrat de croissance (7) est aminci.

14. Puce semi-conductrice optoélectronique selon l'une quelconque des revendications 2 à 13,
dans laquelle la puce semi-conductrice est amenée à croître dans un mode de croissance sur face de Ga.

15. Composant optoélectronique, comportant une puce semi-conductrice optoélectronique selon au moins l'une des revendications précédentes, comportant des bornes (183, 184) par l'intermédiaire desquelles un contact électrique peut être établi avec la puce semi-conductrice optoélectronique (20).

16. Procédé de fabrication d'une puce semi-conductrice optoélectronique comportant la série suivante de régions dans une direction de croissance (c) de la puce semi-conductrice (20) :
- une couche barrière dopée p (1) pour une région active (2),
- la région active (2), qui est apte à générer un rayonnement électromagnétique et est à base d'un semi-conducteur à composé hexagonal, et
- une couche barrière dopée n (3) pour la région active (2), dans lequel
- la région active est à base d'un système de matériau semi-conducteur III-V d'In_{y}Ga_{1-x-y}AlₓN, avec 0 ≤ x ≤ 1, 0 ≤ y≤1 et x + y ≤ 1,
- lorsqu'elle est vue dans la direction de croissance (c), la couche barrière dopée p (1) est disposée en amont d'un contact tunnel (5),
- le contact tunnel (5) comporte une région à fort dopage n (5a) et une région à fort dopage p (5b) qui est dopée par un matériau de dopage p,
- le contact tunnel (5) comporte une barrière de diffusion (14) entre les deux régions (5a, 5b) du contact tunnel (5),
- la barrière de diffusion (14) est apte à augmenter ou réduire une diffusion du matériau de dopage p dans la région à fort dopage n (5b) du contact tunnel (5),
- la barrière de diffusion (14) est une couche d'AlₓGa₁₋ₓN ayant une concentration en aluminium x au moins à 60 pour cent,
dans lequel les régions suivantes sont déposées sur une tranche dans l'ordre indiqué :
a) la couche barrière dopée p (1) destinée à la région active (2) de la puce semi-conductrice,
b) la région active (2),
c) la couche barrière dopée n (3) destinée à la région active (2).

17. Procédé selon la revendication 16,
dans lequel l'un des procédés d'épitaxie suivants est utilisé :
l'épitaxie en phase gazeuse organométallique,
l'épitaxie par faisceau moléculaire, l'épitaxie en phase gazeuse d'hydrure.

18. Procédé selon l'une quelconque des revendications 16 ou 17,
dans lequel la puce semi-conductrice est amenée à croître dans un mode de croissance sur face de Ga.
